# EUROPÄISCHE PATENTSCHRIFT

(11) **EP 2 887 081 B1**
(45) Veröffentlichungstag und Bekanntmachung des Hinweises auf die Patenterteilung: **22.11.2023**
(21) Anmeldenummer: 14199034.1
(22) Anmeldetag: 18.12.2014
(51) Int. Cl.: G01R 31/52, B60L 3/00

(54) **Vorrichtung zur Isolationsüberwachung**
Device for insulation monitoring
Dispositif destiné à la surveillance d'isolation

(30) Priorität: 19.12.2013 DE 102013226595
(43) Veröffentlichungstag der Anmeldung: 24.06.2015
(73) Patentinhaber: HELLA GmbH & Co. KGaA, 59552 Lippstadt (DE); Bender GmbH & Co. KG, 35305 Grünberg (DE)
(72) Erfinder: Kullick, Sven, 59558 Lippstadt (DE); Lehr, Mario, 35305 Grünberg-Reinhardshain (DE); Jäger, Hans-Jürgen, 36304 Alsfeld (DE); Weiß, Carsten, 35321 Laubach (DE)
(74) Vertreter: Grauel, Andreas

(56) Entgegenhaltungen:
- EP-A1- 1 146 345
- DE-A1- 10 212 493
- DE-A1-102006 050 529
- DE-B3-102014 201 044
- DE-C1- 4 037 860
- US-A- 5 760 587

## Beschreibung

### Technisches Gebiet

Die Erfindung betrifft eine Anordnung eines Hochvoltnetzes, eines Niedervoltnetzes und einer Vorrichtung zur Isolationsüberwachung, insbesondere für ein Kraftfahrzeug.

### Stand der Technik

Kraftfahrzeuge mit elektrischem Antrieb, so genannte Elektrofahrzeuge oder auch Hybridfahrzeuge, weisen in der Regel ein Hochspannungsnetz (HV) und ein Niederspannungsnetz (LV) auf. Diese beiden Netze können dabei in einer IT-Topologie aufgebaut sein, wobei die beiden Netze durch Isolationsvorrichtungen voneinander galvanisch getrennt sind. Dies ermöglicht eine höhere Verfügbarkeit und Sicherheit zum Schutz gegen elektrischen Schlag bei einem Einfachfehler in der elektrischen Isolation. Zur Erkennung und Meldung eines solchen Einfachfehlers werden beide Netze auf ausreichende Isolation untereinander überwacht. Diese Isolationsüberwachung erfolgt mittels eines passiven Verfahrens oder mittels aktiven Verfahrens, wobei der Isolationswächter mit einer Ankopplung an HV+ bzw. HV- angeschlossen wird und zusätzlich mit dem Fahrzeugchassis des Kraftfahrzeugs verbunden wird. Beim dem passiven Unsymmetrie-Verfahren wird über eine differentielle Spannungsmessung der beiden Hochspannungsphasen L+ und L- gegenüber einem gemeinsamen Messpunkt eine Unsymmetrie erkannt, die durch einen Isolationsfehler verursacht wird. Dabei wird die Verstimmung einer Messbrücke ausgewertet, um die Unsymmetrie zu erkennen.

Das passive 3-Voltmeter-Verfahren ermittelt den Isolationszustand durch die Messung von 3 Spannungslagen im System. Dies sind die Systemspannung (HV) sowie die Verlagerungsspannungen der beiden Ankoppelpfade an HV+ bzw. HV-, welche nacheinander zu- und weggeschaltet werden, um die Messbrücke künstlich zu verstimmen.

Die passiven Verfahren verwenden üblicherweise zum Ermitteln des Isolationsfehlers eine HV-Spannung von mehr als 100V als Hilfsgröße. Das HV-System muss entsprechend eingeschaltet bzw. mit Spannung beaufschlagt sein, um den Isolationswert bestimmen zu können. Ein Isolationsfehler kann somit nur bei einem eingeschalteten HV-System ermittelt werden. Im Fehlerfall wird in der Regel das fehlerhafte System abgeschaltet, was die Wiederfreigabe erschwert oder verhindert, weil die Isolationswertbestimmung gerade auf Eigenschaften des eingeschalteten Systems beruht.

Weiterhin ist es nachteilig, dass das Unsymmetrie-Verfahren keine symmetrischen Isolationsfehler feststellen kann. Dies bewirkt ein erhöhtes Brandrisiko für das Fahrzeug, da gegebenenfalls ein vorhandener Isolationsfehler nicht erkannt werden kann.

Bei dem aktiven Messverfahren wird dem HV-System eine selbst erzeugte pulsförmige Messspannung überlagert, welche gegenüber Fahrzeugmasse/Chassis eingespeist wird. Dies hat den Nachteil des größeren Aufwands, da die Messspannung selbst erzeugt werden muss. Der Vorteil liegt in der Möglichkeit die Isolationsmessung auch ohne vorhandene HV-Spannung, also im deaktivierten/ausgeschalteten System, durchführen zu können.

Dabei arbeiten die Isolationsüberwachungsverfahren, also das unsymmetrische Verfahren als auch das aktive Verfahren, in der Regel mit der besten Messgenauigkeit im Bereich des verwendeten Innenwiderstandes des Ankoppelpfades.

Dabei besteht ein HV-System in der Regel aus mehreren Komponenten, wie der Ladeeinheit, dem Energiespeicher und einem Zwischenkreis mit Antriebsstrang. In der Regel sind diese Komponenten über so genannte Hauptschütze miteinander verbunden und können voneinander getrennt werden.

Insgesamt zeigt sich bei der Überwachung der Isolation im Systemverbund, dass nur ein Isolationswächter je HV-System-Komponente verwendet werden kann, weil sich mehrere Isolationswächter gegenseitig negativ beeinflussen würden. Daher ist der Isolationswächter in einen bestimmten Abschnitt des HV-Systems zu verbauen. Dabei ist jeder der mindestens drei Fahrzeugabschnitte, wie der Ladezwischenkreis, der HV-Zwischenkreis und die HV-Batterie, als ein eigener Bereich zu betrachten, solange das Fahrzeug nicht freigegeben ist (Fahrbetrieb bzw. Ladevorgang). Bei Verwendung nur eines Isolationswächters kann dieser nur einen bestimmten Abschnitt überwachen und nicht feststellen, ob die weiteren Fahrzeugabschnitte fehlerfrei oder fehlerbehaftet sind. Dies führt gegebenenfalls zu Nachteilen, da nicht überwachte Systemabschnitte mit überwachten Systemabschnitten zusammen geschaltet werden müssen.

Darüber hinaus ist es eine Herausforderung, die Fehlfunktion eines der Hauptschütze zu erkennen. Bleibt ein Schütz geschlossen, obwohl ein Öffnen erforderlich ist, so steigt das Sicherheitsrisiko an, da vermeintlich getrennte Systemabschnitte unwissentlich verbunden sind.

Die DE 10 2006 050 529 A1 offenbart eine Anordnung nach dem Oberbegriff von Anspruch 1.

Die DE 102 12 493 A1 offenbarte eine Anordnung einer Isolationsüberwachung eines elektrisch von Massepotential einer Einrichtung isolierten Gleichstromnetzes.

Die US 5 760 587, die DE 40 37 860 C1 und die EP 1 146 345 A1 offenbarten Anordnungen zur elektrischen Überwachung von Stromnetzen.

### Darstellung der Erfindung Aufgabe, Lösuna, Vorteile

Es ist die Aufgabe der Erfindung eine Anordnung eines Hochvoltnetzes, eines Niedervoltnetzes und einer Vorrichtung zur Isolationsüberwachung, insbesondere eines Kraftfahrzeugs, zu schaffen, welche gegenüber dem Stand eine verbesserte Isolationsüberwachung erlaubt.

Die Aufgabe wird mit den Merkmalen von Anspruch 1 gelöst.

Ein Ausführungsbeispiel der Erfindung betrifft eine Anordnung eines Hochvoltnetzes, eines Niedervoltnetzes und einer Vorrichtung zur Isolationsüberwachung zwischen dem Niedervoltnetz und dem Hochvoltnetz, wobei die Vorrichtung sowohl mit einer Hochvoltplusverbindung als auch mit einer Hochvoltminusverbindung als auch mit dem Niedervoltnetz verbindbar ist, wobei die Vorrichtung eine Mehrzahl von elektrischen Kontakten zur Ankopplung von Überwachungsverbindungen an den Hockvoltkreis mittels jeweils einer Hochvoltplusverbindung und mittels jeweils einer Hochvoltminusverbindung aufweist, die mit verschiedenen Abschnitten des Hochvoltnetzes verbindbar sind. Dadurch können aufgrund der mehreren Ankopplungen verschiedene Kombinationen des aktiven und des passiven Verfahrens oder von zwei aktiven bzw. zwei passiven Verfahren durchgeführt werden, was die Isolationsüberwachung verbessert.

Erfindungsgemäß ist zumindest eine erste Überwachungsverbindung abschaltbar und zumindest eine zweite Überwachungsverbindung fest verbunden. Dadurch kann ein aktives oder passives Verfahren abschaltbar sein, während ein passives oder aktives Verfahren beibehalten wird.

Auch ist es vorteilhaft, wenn aktive oder passive Überwachungsverfahren zur Überwachung der Isolation an einer Überwachungsverbindung durchgeführt werden. Dadurch wird eine Verbesserung der Qualität der Überwachung erreicht.

Erfindungsgemäß sind die Abschnitte des Hochvoltnetzes durch Schaltvorrichtungen voneinander trennbar.

Erfindungsgemäß ist der Innenwiderstand der nicht abschaltbaren Überwachungsverbindungen um zumindest den Faktor 10 größer als bei der abschaltbaren Überwachungsverbindung. Dadurch wird eine gegenseitige Beeinflussung während des Messbetriebes reduziert oder vermieden.

Weitere vorteilhafte Ausgestaltungen sind durch die nachfolgende Figurenbeschreibung und durch die Unteransprüche beschrieben.

### Kurze Beschreibung der Zeichnung

Nachstehend wird die Erfindung auf der Grundlage zumindest eines Ausführungsbeispiels anhand der Zeichnung näher erläutert. Es zeigt:

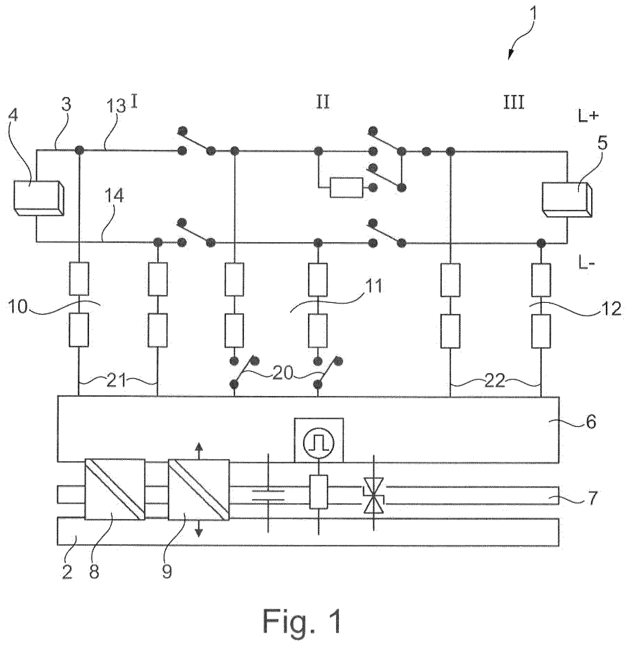

- Fig. 1: eine schematische Ansicht einer Vorrichtung zur Isolationsüberwachung.

### Bevorzugte Ausführung der Erfindung

Die Figur 1 zeigt in einem erfindungsgemäßen Beispiel eine Vorrichtung 1 zur Isolationsüberwachung 1 insbesondere für ein Elektrofahrzeug. Das Fahrzeug weist dabei ein Niedervoltbordnetz 2 von etwa 12/24V auf. Weiterhin weist das Fahrzeug einen Hochvoltkreislauf 3 auf. In diesem Hochvoltkreislauf sind eine Batterieladeeinheit 4 und eine zu ladende Batterie 5 vorgesehen. Die Batterieladeeinheit 4 ist mit der Batterie 5 elektrisch verbunden.

Die Vorrichtung zur Isolationsüberwachung 6 ist zwischen den Hochvoltkreis 3 und das Niedervoltnetz 2 geschaltet. Dabei ist die Vorrichtung zur Isolationsüberwachung 6 mit dem Niedervoltnetz durch eine ggf. funktionale Isolation 7 getrennt, wobei eine Verbindung über eine galvanisch getrennte Spannungsversorgung 8 und eine galvanisch getrennte Kommunikationseinheit 9 vorgesehen ist. Alternativ können die Spannungsversorgung und die Kommunikationseinheit auch ohne galvanische Trennung in einem Block liegen.

Der Hochvoltkreis 3 ist dabei in drei Abschnitte I, II und III unterteilt. Zwischen der Vorrichtung zur Isolationsüberwachung 6 und dem Hochvoltkreis 3 sind in jedem Abschnitt Überwachungsverbindungen 10, 11 und 12 vorgesehen, welche jeweils mit der positiven Verbindung 13 und der negativen Verbindung 14, des Hochvoltkreises 3 verbunden sind.

Im Betrieb ermittelt ein passives Verfahren im Abschnitt III den Isolationszustand der Gesamtverschaltung, da die Vorrichtung zur Isolationsüberwachung mit der Spannung der Batterie die notwendige Hilfsgröße zur Isolationsmessung direkt zur Verfügung hat.

Der Abschnitt II liegt ohne HV-Spannung vor und erzeugt sich durch das aktive Verfahren selbst die Hilfsgröße.

Im Abschnitt I wird die Hilfsgröße für ein passives Verfahren durch die Ladeeinheit 4 bereitgestellt. Da das passive Verfahren nur unsymmetrische Fehler erkennt, werden symmetrische Fehler nach dem Zusammenschalten der weiteren Fahrzeugabschnitte durch das aktive Verfahren erkannt.

Bei einem weiteren vorteilhaften Ausführungsbeispiel der Erfindung wird bei getrennten Abschnitten mit geöffnetem Hauptschalter in allen Abschnitten I bis III eine aktive Messung durchgeführt. Dabei stellt ein gemeinsamer Messpulsgenerator die Hilfsgröße zur Messung bereit, welcher den Messpuls gegen das Chassis des Fahrzeugs einspeist. Die Ankopplungen haben einen ähnlich großen Innenwiderstand und sind wegschaltbar.

Da die Messung auf einem gemeinsamen Messpuls beruht, richtet sich die Messdauer für die einzelnen Abschnitte nach der Messdauer des Abschnittes mit dem höchsten Isolationswiderstand und der größten Netzableitkapazität. Symmetrische und unsymmetrische Isolationsfehler können jederzeit erkannt werden.

Beim Zusammenschalten der Abschnitte können parallel liegende Ankoppelpfade weggeschaltet werden, um eine Beeinflussung zu vermeiden.

Ist das gesamte System zusammengeschaltet, kann die Isolationsüberwachung über eine einzige Ankopplung realisiert werden.

Bei der Erfindung verfügt die Vorrichtung zur Isolationsüberwachung über zwei oder mehrere Ankopplungen, die an verschiedenen Positionen im zu überwachenden System, wie beispielsweise dem Hochvoltkreis eines Fahrzeugs, angekoppelt werden können.

Dabei stellt eine erste Ankopplung 20 eine wegschaltbare Ankopplung mit einem für die Applikation sinnvollen Innenwiderstand dar. In Elektro- und Hybridfahrzeugen kann das Niveau des Innenwiderstandes zwischen 180kΩ und 2MΩ liegen.

Die weiteren Ankopplungen zwei 21 bis N 22, mit N als eine ganze Zahl größer als 2, haben einen um den Faktor 10 höheren, nicht wegschaltbaren Innenwiderstand, um eine gegenseitige Beeinflussung während des Messbetriebes zu vermeiden, wenn alle Fahrzeugabschnitte I bis III zusammen geschaltet sind. Wenn es erforderlich ist, auch die weiteren Ankopplungen mit einem ähnlich großen Innenwiderstand aufzubauen, ist es vorteilhaft, wenn diese ebenfalls wegschaltbar ausgelegt sind.

Durch eine ähnlich große Auslegung des Innenwiderstandes zwischen den Ankopplungen 21 und 22 zu der ersten Ankopplung 20 ergibt sich der Vorteil, dass die an den verschiedenen Ankopplungen eingesetzten Messverfahren mit der gleichen Messgenauigkeit arbeiten können.

Dadurch kann mittels der Vorrichtung zur Isolationsüberwachung durch diese mehreren Ankopplungen die Kombination des aktiven und des passiven Verfahrens durchgeführt werden.

Generell können so auch mehrere aktive bzw. passive Verfahren gleichzeitig arbeiten, da die gemeinsame Steuer- und Auswerteeinheit mit dem Messpulsgenerator eine Synchronisierung der Messergebnisse der einzelnen Ankoppelpfade ermöglicht.

Es wird die gleichzeitige Überwachung von nicht verbundenen Fahrzeugabschnitten ermöglicht, ohne dass das gesamte Hochvolt- System aktiv verschaltet ist. Es müssen somit auch keine nicht überwachten Fahrzeugabschnitte mit überwachten Fahrzeugabschnitten verschaltet werden, um das Fahrzeug fahren bzw. laden zu können.

Durch die Überwachung getrennter Fahrzeugabschnitte kann bei Auftreten eines Isolationsfehlers auch der Fehlerort bestimmt werden, was die Fehlersuche für den Service erheblich vereinfacht.

Mit jeder der Ankopplungen kann zusätzlich auch die HV-Spannung des jeweiligen Abschnitts via Differenzspannungsmessung ermittelt werden. Dadurch kann in jedem über eine Ankopplung verbundenen Fahrzeugabschnitt die Systemspannung auch bei geöffneten Hauptschützen ermittelt werden. Sind die Hauptschütze eines jeden Abschnittes korrekt geschlossen, so muss in jedem der Abschnitte auch die gleiche Systemspannung gemessen werden können. Werden diese gemessenen Spannungen an jedem Ankoppelpfad miteinander verglichen, wie in einem Kreuzvergleich, ist es möglich, neben der Spannungsübereinstimmung auch eine Abweichung zwischen den verschiedenen Messstellen festzustellen.

Eine Abweichung zwischen den Spannungsmessungen verschiedener Fahrzeugabschnitte tritt normalerweise nur auf, wenn die Hauptschütze zwischen den Fahrzeugabschnitten geöffnet sind.

Bei Vorliegen einer Fehlfunktion der Hauptschütze, wie beispielsweise einer der Schütze oder die Schütze öffnen nicht trotz versuchter Ansteuerung zum Öffnen, würde zunächst ein Unterschied zwischen den Ergebnissen der Spannungsmessungen erwartet werden. Tritt dieser Unterschied nicht auf, so kann auf die Fehlfunktion der Schütze geschlossen werden.

Umgekehrt kann es eine Fehlfunktion beim Schließen der Schütze geben, wenn ein Hauptschütz trotz versuchter Ansteuerung nicht schließt. Dabei würden zunächst gleiche Messergebnisse bei den Spannungsmessungen erwartet werden. Weichen die Messergebnisse wider Erwarten jedoch voneinander ab, so kann ebenfalls auf eine Fehlfunktion der Schütze geschlossen werden.

Insgesamt ergibt sich durch die Realisierung einer Spannungsmessung und Isolationsmessung über die gleiche Ankopplung eine kombinierte Vorrichtung zur Messung beider Größen. Eine Realisierung durch zwei getrennte Messeinrichtungen ist somit nicht mehr notwendig und reduziert die Kosten des Gesamtfahrzeuges.

## Patentansprüche

1. Anordnung eines Hochvoltnetzes, eines Niedervoltnetzes und einer Vorrichtung zur Isolationsüberwachung zwischen dem Niedervoltnetz und dem Hochvoltnetz, wobei die Vorrichtung sowohl mit einer Hochvoltplusverbindung als auch mit einer Hochvoltminusverbindung als auch mit dem Niedervoltnetz verbindbar ist, wobei die Vorrichtung eine Mehrzahl von elektrischen Kontakten zur Ankopplung von Überwachungsverbindungen an den Hockvoltkreis mittels jeweils einer Hochvoltplusverbindung und mittels jeweils einer Hochvoltminusverbindung aufweist, die in verschiedenen Abschnitten des Hochvoltnetzes verbindbar sind, wobei zumindest eine erste Überwachungsverbindung abschaltbar ist und zumindest eine zweite Überwachungsverbindung fest verbunden ist und wobei die Abschnitte des Hochvoltnetzes durch Schaltvorrichtungen voneinander trennbar sind, **dadurch gekennzeichnet, dass**
der Innenwiderstand der nicht abschaltbaren Überwachungsverbindungen um zumindest den Faktor 10 größer ist als bei der abschaltbaren Überwachungsverbindung.

2. Anordnung nach Anspruch 1, **dadurch gekennzeichnet, dass** aktive und/oder passive Überwachungsverfahren zur Überwachung der Isolation an einer Überwachungsverbindung durchgeführt werden.

3. Anordnung nach einem der vorhergehenden Ansprüche, **dadurch gekennzeichnet, dass** die Überwachungsverbindungen einen vordefinierten Innenwiderstand aufweisen, der von Abschnitt zu Abschnitt unterschiedlich bemessen ist.

4. Anordnung nach einem der vorhergehenden Ansprüche, **dadurch gekennzeichnet, dass** eine Spannungsmessung am HV-System mittels zumindest einer Hochvoltplusverbindung als auch mittels zumindest einer Hochvoltminusverbindung durchführbar ist.

## Claims

1. An arrangement of a high-voltage network, a low-voltage network and a device for insulation monitoring between the low-voltage network and the high-voltage network, wherein the device can be connected to a high-voltage plus connection as well as to a high-voltage minus connection as well as to the low-voltage network, wherein the device has a plurality of electrical contacts for coupling monitoring connections to the high-voltage circuit by means of a respective high-voltage plus connection and by means of a respective high-voltage minus connection which can be connected in different sections of the high-voltage network, wherein at least a first monitoring connection can be switched off and at least a second monitoring connection is fixedly connected and wherein the sections of the high-voltage network can be separated from one another through switching devices, **characterised in that** the internal resistance of the monitoring connections which cannot be switched off is greater by at least the factor 10 than with the monitoring connection which can be switched off.

2. The arrangement according to claim 1, **characterised in that** active and/or passive monitoring methods for monitoring the insulation at a monitoring connection are conducted.

3. The arrangement according to any one of the preceding claims, **characterised in that** the monitoring connections have a predefined internal resistance which is dimensioned differently from section to section.

4. The arrangement according to any one of the preceding claims, **characterised in that** a voltage measurement at the HV system can be conducted by means of at least one high-voltage plus connection and by means of at least one high-voltage minus connection.

## Revendications

1. Agencement d'un réseau haute tension, d'un réseau basse tension et d'un dispositif servant à la surveillance de l'isolation entre le réseau basse tension et le réseau haute tension, où le dispositif peut être connecté aussi bien à une connexion positive haute tension qu'à une connexion négative haute tension ainsi qu'au réseau basse tension, où le dispositif présente une pluralité de contacts électriques servant au couplage de connexions de surveillance au circuit haute tension, respectivement au moyen d'une connexion positive haute tension et, respectivement, au moyen d'une connexion négative haute tension, connexions de surveillance qui peuvent être connectées dans différents tronçons du réseau haute tension, où au moins une première connexion de surveillance peut être déconnectée et au moins une deuxième connexion de surveillance peut être connectée en permanence, et où les tronçons du réseau haute tension peuvent être séparés les uns des autres par des dispositifs de commutation, **caractérisé en ce que** la résistance intérieure des connexions de surveillance ne pouvant pas être déconnectées est au moins d'un facteur de 10 supérieure à celle de la connexion de surveillance pouvant être déconnectée.

2. Agencement selon la revendication 1, **caractérisé en ce que** des procédés de surveillance actifs et/ou passifs servant à la surveillance de l'isolation sont mis en œuvre sur une connexion de surveillance.

3. Agencement selon l'une des revendications précédentes, **caractérisé en ce que** les connexions de surveillance présentent une résistance intérieure prédéfinie qui est mesurée en variant de façon différente d'un tronçon à l'autre.

4. Agencement selon l'une quelconque des revendications précédentes, **caractérisé en ce qu'**une mesure de la tension peut être effectuée sur le système haute tension au moyen au moins d'une connexion positive haute tension, ainsi qu'au moyen au moins d'une connexion négative haute tension.
